# EUROPÄISCHE PATENTSCHRIFT

(11) **EP 0 620 628 B1**
(45) Veröffentlichungstag und Bekanntmachung des Hinweises auf die Patenterteilung: **18.09.1996**
(21) Anmeldenummer: 94105284.7
(22) Anmeldetag: 05.04.1994
(51) Int. Cl.: H02G 3/00, H05K 7/14

(54) **EIB-Modul**
EIB-module
Module d'EIB

(30) Priorität: 10.04.1993 DE 4311883
(43) Veröffentlichungstag der Anmeldung: 19.10.1994
(73) Patentinhaber: Tehalit GmbH, D-67716 Heltersberg (DE)
(72) Erfinder: Pollak,Gottfried,Dipl.-Ing.FH,, D-67714 Waldfischbach-Burgalben (DE); Scherer,Peter,Dipl.-Ing.FH,, D-66287 Quierscheid (DE)
(74) Vertreter: Patentanwälte Möll und Bitterich

(56) Entgegenhaltungen:
- EP-A- 0 262 685
- EP-A- 0 534 538
- FR-A- 2 652 686
- ELEKTROTECHNISCHE ZEITSCHRIFT - ETZ, Bd. 113, Nr. 11, Juni 1992, Berlin DE, Seiten 638-648; R. KNÖRR : 'Programmierbare Gebäudeinstallation'

## Beschreibung

Die Erfindung betrifft EIB-Module, bestehend aus einem universellen Bus-Ankoppler und einem aufgabenspezifischen Endgerät mit bis zu vier Eingangs- und Ausgangskanälen gemäß dem Oberbegriff des Anspruchs 1. Ein EIB-Installation mit EIB-Module gemäß dem Oberbegriff des Anspruchs 1 ist in der Elektrotechnische Zeitschrift-ETZ Bd. 113 (1992) Heft 11 Seiten 638-648 beschrieben. In der Gebäudeinstallationstechnik gewinnt der European Installation Bus (EIBus), wie er von der European Installation Bus Association (EIBA) definiert ist, zunehmend Bedeutung. Während bei der herkömmlichen Elektroinstallation jede Funktion eine eigene Leitung und jedes Steuerungssystem ein separates Netz benötigt, lassen sich mit dem EIBus alle betriebstechnischen Funktionen und Abläufe über eine gemeinsame Leitung erfassen, schalten, steuern, überwachen und melden. Die Energiezuleitung wird ohne Umwege zum Verbraucher geführt. Dabei werden Leitungen eingespart; darüber hinaus läßt sich die Gebäudeinstallation wesentlich einfacher realisieren, später problemlos erweitern und flexibel nutzen.

Der EIBus besteht aus einer zweiadrigen Leitung und busfähigen Installationsgeräten für den Verteilereinbau, für die Aufputz- und Unterputzmontage und für den Einbau in Aktoren, d. h. Verbraucher wie Leuchten, Jalousieantriebe und Heizgeräte. Sensoren, nämlich Lichttaster, Helligkeits- und Temperaturfühler, Windmesser usw. und Aktoren kommunizieren ohne Zentrale miteinander.

Herzstück der herkömmlichen EIB-Installation ist ein zentral angeordneter Verteiler mit EIB-Basisgeräten, Systemgeräten und Anwendungsgeräten. Er wird je nach Anforderung mit EIB-Modulen bestückt. Diese EIB-Module besitzen genormte Abmessungen und werden auf die handelsüblichen Hut-Schienen (DIN EN 50022) aufgerastet, wobei gleichzeitig der vorverdrahtete Bus kontaktiert wird.

Die busfähigen Unterputz-, Aufputz- und Einbaugeräte werden jeweils dort im Gebäude installiert, wo sie ihre Aufgabe erfüllen müssen. Jedes Bus-Gerät besteht prinzipiell aus einem universellen Bus-Ankoppler und einem aufgabenspezifischen Endgerät. Der Bus-Ankoppler wird durch Parametrierung auf das Endgerät eingestellt und kann bis zu vier Funktionen verwalten. Eingangs- und Ausgangskanäle können beliebig kombiniert werden. Bei Unterputzgeräten werden Bus-Ankoppler und Endgerät getrennt geliefert; die Endgeräte, üblicherweise Tastschalter, Temperaturfühler und dergleichen, werden einfach aufgesteckt.

Bus-Ankoppler und Endgerät sind entweder in einem für den Verteilereinbau geeigneten Gehäuse oder in einem Verbraucher untergebracht. Sie können gegebenenfalls auch mittels eines Adapters zusammengesteckt werden. In diesen Fällen sind also ganz spezielle Sensoren und Aktoren mit werksseitig fertiggestellten Verdrahtungen erforderlich. Will der Installateur jedoch beliebige Aktoren und Sensoren mit dem EIB-Bus verbinden, muß er auf der Baustelle umfangreiche Verdrahtungsarbeiten unter Benutzung von zusätzlichen Klemmen, Stützpunkten, Dosen und dergleichen durchführen. Dies ist nicht zuletzt dadurch bedingt, daß die handelsüblichen EIB-Module nur potentialfreie Schaltausgänge bzw. Sensoreingänge besitzen.

Hier setzt nun die vorliegende Erfindung an und löst die Aufgabe, die auf der Baustelle durchzuführenden Arbeiten zu vereinfachen und zu verkürzen, durch einen EIB-Modul mit den Merkmalen gemäß Anspruch 1.

Diese Anordnung hat den Vorteil, daß der Installateur die ihm geläufige Klemmenanordnung vorfindet, an die er die drei Drähte L, N, PE seiner elektrischen Leitung anklemmt. Montage und Verdrahtung von Stützklemmen, Hilfsschaltungen und dergleichen entfallen.

Gemäß einer vorteilhaften Weiterbildung der Erfindung ist zusätzlich zu den üblichen drei Anschlußklemmen noch eine zweite Spannungsversorgungsklemme L und/oder eine zweite Neutralleiterklemme N zugeordnet. Die zusätzliche Spannungsversorgungsklemme L empfiehlt sich insbesondere bei Eingangskanälen, beispielsweise um dem Sensor die erforderliche Betriebsspannung getrennt zuführen zu können. Die zusätzliche Neutralleiterklemme N empfiehlt sich insbesondere bei Ausgangskanälen, um bei Bedarf aus dem potentialbehafteten Schaltkontakt einen Schaltkontakt anderen Potentials zu machen, mit dem beliebige Stromkreise und beliebige Spannungen geschaltet werden können.

Die letztgenannte Maßnahme läßt sich insbesondere dann leicht realisieren, wenn gemäß einer Weiterbildung der Erfindung wenigstens ein Draht der werkseitigen Verdrahtung zwischen den beiden Klemmenblöcken lösbar ist.

Eine spezielle Anwendung der EIB-Module ist der Einsatz in Elektroinstallationskanälen, wie sie beispielsweise in der DE-C-25 16 404 beschrieben und in großen Stückzahlen weltweit im Einsatz sind. Hierzu wird der EIB-Modul in ein Montageelement für Elektroinstallationskanäle integriert, wie es beispielsweise in der DE-U-92 03 064 beschrieben ist. Diese Anordnung ist Gegenstand des Anspruchs 6 mit entsprechenden Weiterbildungen gemäß der Ansprüche 7 und 8.

Anhand der Zeichnung soll die Erfindung in Form von Ausführungsbeispielen näher erläutert werden. Es zeigen
- Fig. 1: eine Draufsicht auf einen ELektroinstallationskanal mit eingesetztem Montageelement mit eingebautem EIB-Modul,
- Fig. 2: eine perspektivische Darstellung des Montageelements der Fig. 1 mit zugehörigem Deckel,
- Fig. 3: ein erstes Ausführungsbeispiel einer KLemmenanordnung und Verdrahtung für Ausgangskanäle,
- Fig. 4: ein zweites Ausführungsbeispiel einer Klemmenanordnung und Verdrahtung für Ausgangskanäle und
- Fig. 5: ein Ausführungsbeispiel einer Klemmenanordnung und Verdrahtung für Eingangskanäle.

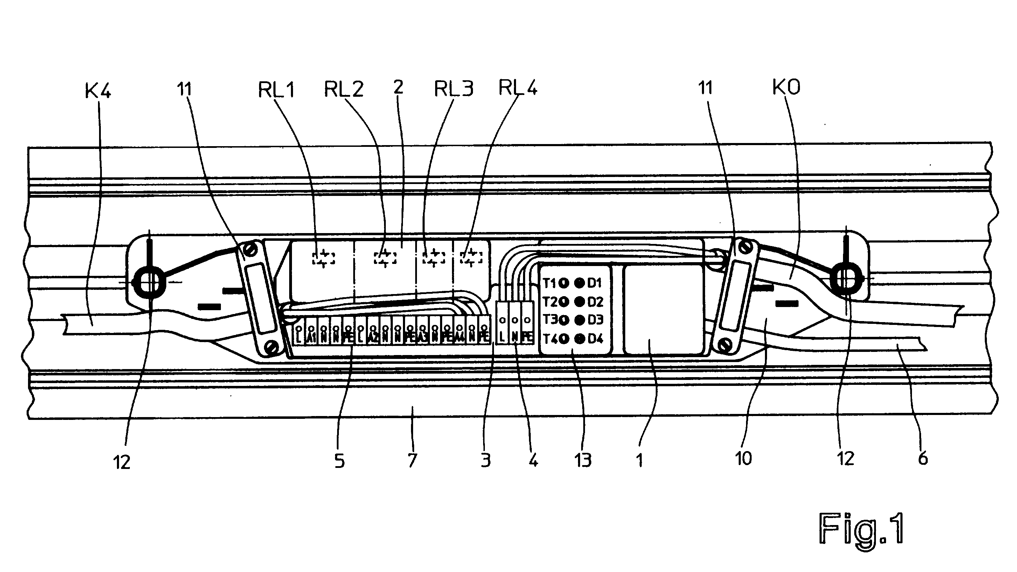

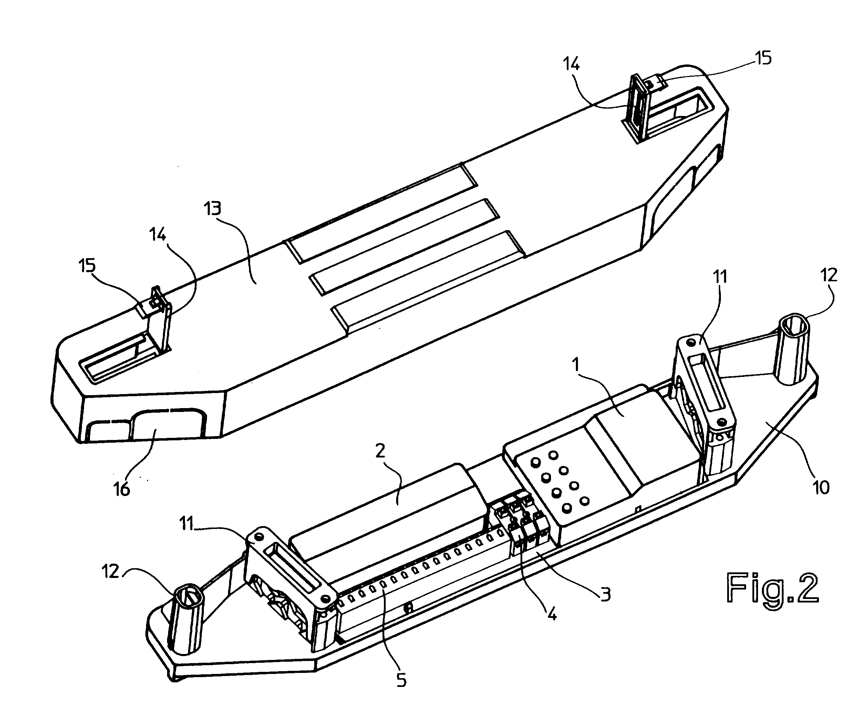

Fig. 1 zeigt eine Draufsicht auf einen Elektroinstallationskanal 7 mit abgenommenem Deckel. Eine EIBus-Leitung 6 ist mit einem Busankoppler 1 verbunden. An der Kanalrückwand ist das Unterteil 10 eines Montageelements zum lösbaren Befestigen von Installationsgeräten befestigt, wie es anhand der Fig. 2 noch näher erläutert werden soll.

Das eigentliche EIB-Modul besteht aus dem universellen, programmierbaren Bus-Ankoppler 1 und einem zugehörigen Endgerät 2, hier in Form von vier Ausgangskanälen mit Schaltkontakten, jeweils aktiviert über ein Relais RL1, RL2, RL3, RL4. Bus-Ankoppler 1 und Endgerät 2 sitzen auf einer gedruckten Schaltungsplatine 3, die ihrerseits auf dem Unterteil 10 des Montageelements befestigt ist.

Auf der gedruckten Schaltungsplatine 3 sind darüber hinaus ein dreipoliger Klemmenblock 4 und ein vielpoliger Klemmenblock 5 befestigt. Der dreipolige Klemmenblock 4 dient zum Anschluß einer handelsüblichen Stromversorgungsleitung K0. An den vielpoligen Klemmenblock 5 können handelsübliche Stromverbindungsleitungen angeschlossen werden, wobei der Übersichtlichkeit halber nur die zum Ausgangskanal 4 gehörende Leitung K4 zeichnerisch dargestellt ist. Die gleichnamigen Pole L, N, PE der beiden Klemmenblöcke 4, 5 sind über gedruckte Leiterbahnen auf der Platine 3 verdrahtet. Die Ausgangsklemmen A1, A2, A3, A4 sind mit je einem relaisgesteuerten Schaltkontakt verbunden. Zugentlastungen 11 fixieren die Leitungen K0, K4.

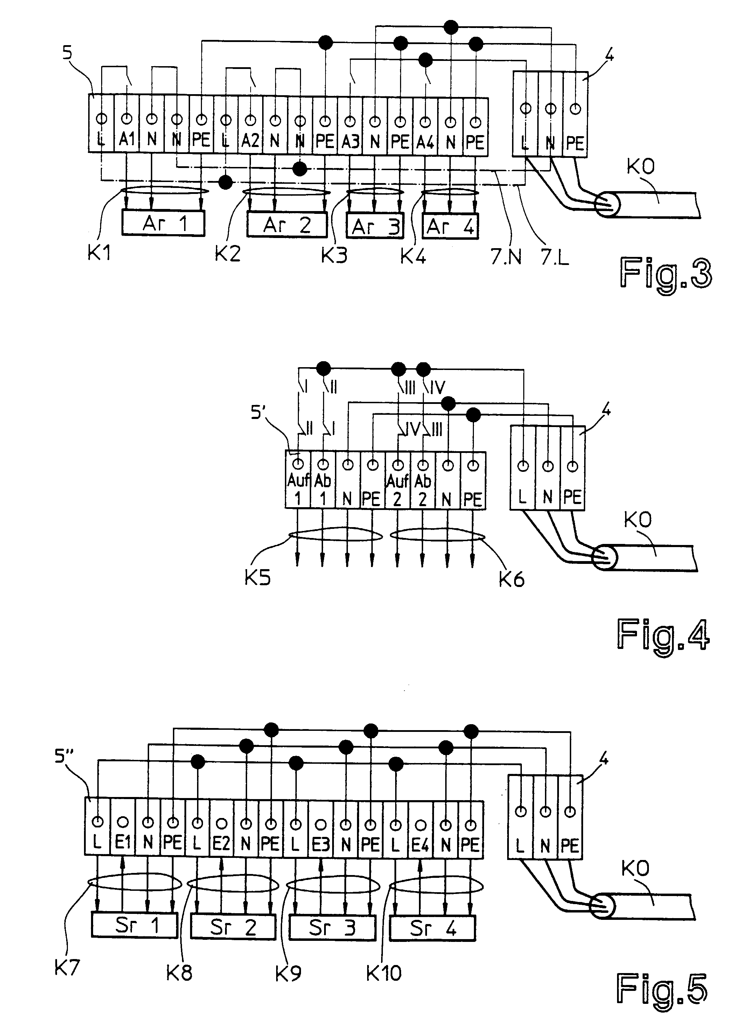

Wie die Zeichnung zeigt, sind den Kanälen 1 und 2 je fünf Klemmen, den Kanälen 3 und 4 beispielsweise je drei Klemmen zugeordnet. Die sich daraus ergebenden Konsequenzen sollen anhand der Fig. 3 und 4 im einzelnen erläutert werden.

Ein Testfeld 13 neben dem Bus-Ankoppler 1 zeigt zwei für den Installateur sehr nützliche Einrichtungen in Form je einer Signaldiode D1, D2, D3, D4 und je eines Testtasters T1, T2, T3, T4 für jeden der vier Ausgangskanäle. Die Signaldioden D1 ... D4 leuchten auf, wenn ein für den jeweiligen Kanal bestimmtes Bus-Schaltsignal erkannt wird. Auf diese Weise kann der Installateur sofort erkennen, ob bei einer Fehlfunktion der Fehler auf der Bus-Seite zu suchen ist.

Durch Druck auf einen der Testtaster T1 ... T4 kann der Installateur darüber hinaus das zugehörige Relais RL1 ... RL4 zum Anzug bringen, worauf der an den entsprechenden Klemmenblock angeschlossene Aktor aktiviert wird. Dieser

Test kann auch schon vorgenommen werden, wenn EIBus bzw. Bus-Ankoppler 1 noch nicht programmiert sind, so daß eine Verbindungsverdrahtung schon vorab auf Funktionsfähigkeit geprüft werden kann. Des weiteren hat der Installateur so die Möglichkeit, bei einer Aktor-Fehlfunktion mit Sicherheit zu unterscheiden, ob der für die Fehlfunktion verantwortliche Fehler auf der Bus-Seite oder auf der Seite der Verbindungsverdrahtung zu suchen ist.

Fig. 2 zeigt in perspektivischer Darstellung als Sprengbild das Montageelement der Fig. 1 mit eingesetztem EIB-Modul 1, 2, 3, 4, 5. Man erkennt das Unterteil 10 mit Zugentlastungsklemmen 11 sowie mit zwei Deckelhaltedomen 12.

Ein wannenförmiges Oberteil 13 kann auf das Unterteil 10 aufgesetzt werden. Die lösbare Verbindung zwischen Unterteil 10 und Deckel 13 erfolgt mit Hilfe von Rastleisten 15, die an Klapphaltern 14 angeformt sind, die ihrerseits mittels Filmscharnier mit dem Deckel 13 verbunden sind. Ausbrechbare öffnungen 16 ermöglichen den ungestörten Durchgang der Kabel.

Fig. 3 zeigt als erstes Ausführungsbeispiel die Klemmanordnung der Fig. 1 für Ausgangskanäle. An den Klemmenblock 4 mit den drei Klemmen L, N, PE ist die Spannungsversorgungsleitung K0 dreipolig angeklemmt. Die Verdrahtung zwischen dem Klemmenblock 4 und dem vielpoligen Klemmenblock 5 erfolgt einerseits durch gedruckte Leiterbahnen (ausgezogene Linien), andererseits durch extern verlegte Leitungen 7.N, 7.L (strichpunktierte Linien). Diese gemischte Verdrahtung bietet die Möglichkeit, durch Abtrennen der externen Verdrahtung 7.N, 7.L mit den den Ausgangsklemmen A1, A2 zugeordneten Schaltausgängen ein von der Spannungsversorgung unabhängiges Spannungspotential zu schalten. Dies wäre bei nur durch gedruckte Leiterbahnen verschalteten Kanälen 3 und 4 nicht möglich.

Die Verbindung zwischen den jedem Ausgangskanal zugeordneten Klemmen und den Aktoren AR1, AR2, AR3, AR4 erfolgt mit Hilfe handelsüblicher dreiadriger Verbindungsleitungen K1, K2, K3, K4, die ohne externe Stützpunkte schnell und sicher montiert werden können.

Fig. 4 zeigt ein abgewandeltes Ausführungsbeisplel für Ausgangskanäle. Hier sind jeweils zwei Ausgangskanäle I, II bzw. III, IV so zusammengeschaltet und gegeneinander verriegelt, daß zwei Antriebsmotoren, beispielsweise für einen Rolladen, angesteuert werden können, wobei die Verbindung zwischen Klemmenblock 5' und Aktoren über vieradrige Verbindungsleitungen K5, K6 erfolgt. Auch hier sind nur einfache Verdrahtungsarbeiten auf der Baustelle erforderlich.

Fig. 5 zeigt ein Ausführungsbeispiel der Klemmenanordnung und Verdrahtung für vier Eingangskanäle E1, E2, E3, E4. Die gleichnamigen Klemmen L, N, PE der beiden Klemmenblöcke 4, 5'' sind über gedruckte Leiterbahnen fest miteinander verbunden. Vier externe Sensoren SR1, SR2, SR3, SR4 sind über vieradrige Verbindungsleitungen K7, K8, K9, K10 mit den entsprechenden Klemmen verbunden. Auch hier sind keinerlei Stützklemmen erforderlich, die Verdrahtungsarbeit ist schnell und mit großer Sicherheit erledigt.

## Patentansprüche

1. EIB-Modul, bestehend aus einem universellen
Busankoppler (1) und einem aufgabenspezifischen Endgerät (2) mit Eingangs- und/oder Ausgangskanälen (El, E2, E3, E4; Al, A2, A3, A4), gekennzeichnet durch die Merkmale:
- es ist eine Platine (3), insbesondere eine gedruckte Schaltungsplatine, vorgesehen, die Busankoppler (1) und Endgerät (2) verbindet,
- es ist ein dreipoliger Leitungsklemmenblock (4) zum Anklemmen einer Versorgungsspannungsleitung (KO) vorgesehen,
- es ist ein vielpoliger Leitungsklemmenblock (5, 5', 5'') zum Anklemmen von bis zu vier Verbindungsleitungen (K1... K4) vorgesehen,
- gleichnamige Klemmen (PE, N, L) beider Leitungsklemmenblöcke (4; 5, 5', 5'') sind vorverdrahtet.

2. EIB-Modul nach Anspruch 1, gekennzeichnet durch das Merkmal:
- jedem Kanal (El...; Al...) sind wenigstens drei Klemmen des vielpoligen Leitungs klemmenblocks (Ax, N, PE; Ex, N, PE) zugeordnet.

3. EIB-Modul nach Anspruch 2, gekennzeichnet durch das Merkmal:
- den Kanälen (El...; Al...) ist zusätzlich eine Spannungsversorgungsklemme (L) des vielpoligen Leitungs klemmenblocks zugeordnet.

4. EIB-Modul nach Anspruch 2 oder 3, gekennzeichnet durch das Merkmal:
- den Kanälen (El...; A1...) ist zusätzlich eine Neutralleiterklemme (N) des vielpoligen Leitungs klemmenblocks zugeordnet.

5. EIB-Modul nach einem der Ansprüche 1 bis 4,
gekennzeichnet durch das Merkmal:
- wenigstens ein Draht (7.N, 7.L) der Verdrahtung zwischen den beiden Klemmenblöcken (4, 5') ist lösbar.

6. EIB-Modul nach einem der Ansprüche 1 bis 5, gekennzeichnet durch die Merkmale:
- es ist eine Bodenplatte (10) vorgesehen,
- die Bodenplatte (10) trägt wenigstens eine Zugentlastung (11) für Versorgungsleitungen, Verbindungsleitungen (KO, K1) und EIBus-Leitung.

7. EIB-Modul nach Anspruch 6, gekennzeichnet durch das Merkmal:
- die Bodenplatte (10) trägt wenigstens einen Deckelhaltedom (12).

8. EIB-Modul nach Anspruch 6 oder 7, gekennzeichnet durch die Merkmale:
- es ist ein haubenartiger Deckel (13) vorgesehen,
- am Deckel (13) sind Klapphalter (14) mittels Filmscharnier angelenkt,
- an jedem Klapphalter (14) ist eine Rastnase (15) angeformt, die mit dem Deckelhaltedom (2) lösbar verrastet.

## Claims

1. EIB module, consisting of a universal bus coupler (1) and a function-specific terminal device (2) with input and/or output channels (E1, E2, E3, E4; A1, A2, A3, A4),
characterised by the features:
- a board (3), in particular a printed circuit board, is provided which connects the bus coupler (1) and the terminal device (2),
- a three-terminal line terminal block (4) is provided for connecting a supply voltage line (KO),
- a multi-terminal line terminal block (5, 5', 5") is provided for connecting up to four connecting lines (K1,..K4),
- like terminals (PE, N, L) of both line terminal blocks (4; 5, 5', 5") are prewired.

2. EIB module according to claim 1, characterised by the feature:
- at least three terminals (Ax, N, PE; Ex, N, PE) of the multi-terminal line terminal block are associated with each channel (E1...; A1...).

3. EIB module according to claim 2, characterised by the feature:
- a voltage supply terminal (L) of the multi-terminal line terminal block is additionally associated with the channels (E1...; A1...).

4. EIB module according to claim 2 or 3, characterised by the feature:
- a neutral conductor terminal (N) of the multi-terminal line terminal block is additionally associated with the channels (E1...; A1...).

5. EIB module according to one of claims 1 to 4,
characterised by the feature:
- at least one wire (7.N, 7.L) of the wiring between the two terminal blocks (4, 5') is detachable.

6. EIB module according to one of claims 1 to 5,
characterised by the features:
- a bottom plate (10) is provided,
- the bottom plate (10) bears at least one strain relief (11) for supply lines, connecting lines (KO, K1) and the EIBus line.

7. EIB module according to claim 6, characterised by the feature:
- the bottom plate (10) bears at least one cover retaining dome (12).

8. EIB module according to claim 6 or 7, characterised by the features:
- a hood-like cover (13) is provided,
- hinged holders (14) are articulated to the cover (13) by means of film hinges,
- a locking lug (15), which engages with the cover retaining dome (12) in a releasable manner, is moulded onto each hinged holder (14).

## Revendications

1. Module EIB, constitué par un dispositif universel de couplage par bus (1) et par un terminal (2), spécialisé dans les tâches, comprenant des canaux d'entrée et/ou des canaux de sortie (E1, E2, E3, E4 ; A1, A2, A3, A4), caractérisé en ce que l'on monte une plaquette (3), en particulier une plaquette à circuits imprimés, qui raccorde le dispositif de couplage par bus (1) et le terminal (2) ; on monte un répartiteur à trois pôles (4) pour connecter une ligne d'alimentation électrique (KO); on monte un répartiteur **multipolaire** (5, 5', 5") pour connecter un maximum de quatre lignes de connexion (K1 ... K4), et en ce que les bornes de connexion de même nom (PE, N, L) des deux répartiteurs (4 ; 5, 5', 5") sont précâblées.

2. Module EIB selon la revendication 1, caractérisé en ce qu'au moins trois bornes de connexion du répartiteur **multipolaire** (Ax, N, PE ; Ex, N, PE) sont affectées à chaque canal (E1 ... ; A1 ...).

3. Module EIB selon la revendication 2, caractérisé en ce qu'une borne de connexion électrique (L) du répartiteur **multipolaire** est affectée, en plus, aux canaux (E1 ... ; A1 ...).

4. Module EIB selon la revendication 2 ou 3, caractérisé en ce qu'une borne de conducteur neutre (N) du répartiteur **multipolaire** est affectée, en plus, aux canaux (E1 ... ; A1 ...).

5. Module EIB selon l'une quelconque des revendications 1 à 4, caractérisé en ce qu'au moins un câble (7.N, 7.L) du câblage entre les deux répartiteurs (4, 5') est détachable.

6. Module EIB selon l'une quelconque des revendications 1 à 5, caractérisé en ce que l'on monte une plaque de fond (10), qui est munie d'au moins une pince de décharge de traction (11) pour les lignes d'alimentation électrique, les lignes de connexion (KO, K1) et la ligne du bus EIB.

7. Module EIB selon la revendication 6, caractérisé en ce que la plaque de fond (10) est munie d'au moins un pivot de support (12) pour le couvercle.

8. Module EIB selon la revendication 6 ou 7, caractérisé en ce que l'on pose un couvercle (13) en forme de capot, des supports (14) étant articulés sur le couvercle (13) par l'intermédiaire de charnières à film, et une languette d'arrêt (15) etant formée sur chaque support articulé (14), et fixée de manière amovible dans le pivot de support (12) pour le couvercle.
